# EUROPEAN PATENT APPLICATION

(11) **EP 3 474 444 A1**
(43) Date of publication of application: **24.04.2019**
(21) Application number: 17197321.7
(22) Date of filing: 19.10.2017
(51) Int. Cl.: H03F 1/32, H03F 3/189, H03F 3/24

(54) **PRE-DISTORTION CONTROL LOOP FOR RF POWER AMPLIFIERS**

(71) Applicant: Koninklijke Philips N.V., 5656 AE Eindhoven (NL)
(72) Inventor: VAN LIERE, Filips, 5656 AE Eindhoven (NL); DEN BOEF, Jan, 5656 AE Eindhoven (NL); VAN BAKEL, Martinus Johannes Petrus, 5656 AE Eindhoven (NL); VERNICKEL, Peter, 5656 AE Eindhoven (NL); LEUSSLER, Christoph, 5656 AE Eindhoven (NL)
(74) Representative: de Haan, Poul Erik

(57) **Abstract**

The present invention is directed to a radio frequency, RF, transmit system for a magnetic resonance examination system, comprising
a digital baseband modulator (100) configured for generating a digital baseband signal,
a digital feedback control loop (200) configured for injecting a digital pre-distortion signal into the digital baseband signal,
an RF amplifier (400) configured for being driven by the pre-distorted digital base band signal and for providing an analog output signal, wherein
the digital feedback control loop (200) is configured for controlling the digital pre-distortion signal based on the analog output signal to compensate a non-linearity of the RF amplifier (400).

In this way, a continuous feedback control is provided which automatically calibrates a feedforward control.

## Description

### FIELD OF THE INVENTION

The invention relates to the field of Radio Frequency, RF, power amplifiers and in particular to advanced RF pulses such as required for multi-band Magnetic Resonance Imaging, MRI, applications. In particular, the invention relates to an RF transmit system for a magnetic resonance examination system, comprising a digital baseband modulator configured for generating a digital baseband signal and an RF amplifier. The invention further relates to a method for linearizing an RF amplifier for a magnetic resonance examination system and to a non-transitory computer-readable medium, comprising instructions stored thereon.

### BACKGROUND OF THE INVENTION

As is generally known in prior art, non-linearity time varying gain and phase of RF power amplifiers severely limit the fidelity of slice selection in pulsed RF applications for MRI. In particular, non-linearity results in poor slice selection profiles and loss of contrast. These limitations are particularly problematic in multi-band applications where non-linearity's result in unwanted excitation of sidebands or additional slices. The effect of non-linearity increases with baseband modulation waveform bandwidth and therefore limits the application of advanced RF pulses in particular for multi-band applications. Time varying gain and phase, also referred to as drift, are due to dynamic changes in RF amplifier operating conditions such as DC power supply voltage, power transistor junction temperature and load impedance.

Prior art approaches for overcoming these drawbacks make use of feedback control based on monitoring the forward power of the RF amplifier by means of a directional coupler. Although these techniques can compensate for drift, they are inherently bandwidth limited due to the signal delay through the RF power amplifier and directional coupler. Often such techniques are implemented internal to the RF amplifier and therefore cannot make use of the baseband modulation demand.

Other prior art approaches have deployed feed forward techniques, which modify the demand waveform to compensate for signal dependent non-linearity but are not capable of adapting to time varying operating conditions. In addition, such techniques are often cumbersome as they typically require off-line software based processing of the RF pulse modulation waveform.

### SUMMARY OF THE INVENTION

It is an object of the invention to provide a mechanism to compensate for non-linear time varying gain and phase of RF power amplifiers to facilitate the application of advanced RF pulses in particular for multi-band applications for MRI.

According to the invention, this object is addressed by the subject matter of the independent claims. Preferred embodiments of the invention are described in the dependent claims.

Therefore, according to the invention, a radio frequency, RF, transmit system for a magnetic resonance examination system is provided, comprising
a digital baseband modulator configured for generating a digital baseband signal,
a digital feedback control loop configured for injecting a digital pre-distortion signal into the digital baseband signal,
an RF amplifier configured for being driven by the pre-distorted digital base band signal and for providing an analog output signal, wherein
the digital feedback control loop is configured for controlling the digital pre-distortion signal based on the analog output signal to compensate a non-linearity of the RF amplifier.

In this way, by using a digital feed-forward control, to correct baseband modulation, and by using a digital feedback control to respond to dynamic changes in the RF amplifier operating conditions, restrictions on the bandwidth of the baseband signal are removed, which is specifically advantageous when applied to advanced RF pulses such as required for multi-band MRI applications. Therefore, the digital feedback control loop provides a pre-distortion control loop for linearizing output of the RF power amplifier. The pre-distortion control loop combines the use of feed forward control to correct a baseband modulation signal waveform in a signal dependent manner and feedback control to respond to dynamic changes in RF power amplifier operating conditions such as power supply voltage, junction temperature and load impedance. Further, the digital feedback control loop provides continuous and autonomous calibration of the feed forward control due to changed operating conditions. Thus, the invention increases fidelity of slice selection in pulsed RF applications by providing significantly improved slice selection profiles and avoiding loss of contrast, as known from prior art applications.

In other words, the proposed pre-distortion control loop provided by the digital feedback control loop removes the baseband modulation waveform bandwidth limitation associated with traditional RF power amplifier linearization approaches while at the same time maintaining the ability to compensate for time varying RF power amplifier operating conditions. The RF transmit system may additionally consists of an RF transmit antenna, commonly referred to as body coil in MRI systems, which is driven by the RF amplifier with RF energy i.e. the analog output signal to be transmitted. The digital baseband modulator and the digital feedback control loop maybe external to the RF amplifier but may also be integrated in the RF amplifier. The latter alternative provides the advantage of being able to monitor both DC power supply voltage and power transistor junction temperature reducing or potentially eliminating the settling time associated with dynamic changes in RF power amplifier operating conditions. The invention is preferably applied to pulsed RF MRI applications, in particular applications that require use of advanced RF pulse modulation waveforms such as required for multi band techniques. The invention is further applicable to other applications that require highly linear RF power.

According to a preferred embodiment of the invention, the digital feedback control loop is configured for controlling the digital pre-distortion signal by mapping an amplitude of the digital baseband signal to a gain and a phase offset of the analog output signal. Thereby, gain and phase errors of the analog output signal can be corrected for, linearizing the analog output signal.

According to another preferred embodiment of the invention, the digital feedback control loop is configured for controlling the digital pre-distortion signal by
determining a difference between the analog output signal and the digital baseband signal,
integrating the determined difference with a pre-defined integration time corresponding to a settling time of dynamic changes of the non-linearity of the RF amplifier,
adjusting the digital pre-distortion signal with a piece-wise linear approximation of the integrated difference and
applying the adjusted digital pre-distortion signal onto the digital baseband signal by indexing the piece-wise linear approximation with a magnitude of the digital baseband signal to a gain and a phase offset of the analog output signal.

Such control loops steps have been proven very advantageous for generating the digital pre-distortion signal such that a non-linearity of the analog output signal is minimized or even completely eliminated. The piece-wise linear approximation could be, for example, a polynomial approximation. In principle, any function that can be expressed with a limited number of coefficients, can be evaluated relatively efficiently and approximates the non-linearity sufficiently well may be used. The feedback loop would then adjust the coefficients of such a function to reflect the dynamic changes in non-linearity.

According to further preferred embodiment of the invention, the digital feedback control loop is configured for calibrating the digital pre-distortion signal in response to a reference digital baseband signal. The proposed digital feedback control loop comprises the advantage that, once calibrated, feedback control provided by the analog output signal fed to the digital feedback control loop ensures that a calibrated gain and phase are maintained. However, for an initial calibration, the digital feedback control loop is preferably calibrated in regard to potential delay arising from analog components of the RF transmit system such as digital-to-analog converters, delay through the RF amplifier and analog-to-digital converters as described in the following. Calibration may consider an attenuation of the analog RF amplifier demand signal, a forward to reflected signal path delay, a feedback signal path delay and/or a feedback gain and phase of the RF transmit system.

According to another preferred embodiment of the invention, the RF amplifier comprises a digital-to-analog converter configured for converting the pre-distorted digital base band signal for driving the RF amplifier, a directional coupler connected to an output of the RF amplifier and an analog-to digital converter configured for converting a control loop feedback signal derived from the directional coupler and for providing the converted loop feedback signal to the digital feedback control loop for controlling the digital pre-distortion signal. By using forward power of the directional coupler as feedback signal the control loop provided by the digital feedback control loop ensures that the forward power of the RF amplifier follows a baseband modulation demand.

According to even another preferred embodiment of the invention, the system comprises a carrier frequency conversion device arranged between the digital feedback control loop thereby receiving the digital pre-distortion signal and the RF amplifier thereby driving the RF amplifier with the pre-distorted digital base band signal and to shift the digital pre-distortion signal up to a carrier frequency. According to a further preferred embodiment of the invention, the carrier frequency conversion device comprises a carrier frequency generator configured for generating the carrier frequency, a carrier single side band modulator configured for shifting the digital baseband signal up to the carrier frequency, a mixer connected to carrier frequency generator and configured for shifting the analog output signal down to a feedback baseband signal and a low pass filter configured for removing unwanted mixer signal from the feedback baseband signal at twice the carrier frequency. Thus, the low pass filter advantageously removes an unwanted mixer product at twice the carrier frequency for receiving a 'clean' baseband signal for further processing by the control loop.

According to another preferred embodiment of the invention, the digital feedback control loop comprises a second single side band modulator configured for forming a power signal from the analog output signal, a subtraction module configured for subtracting the digital baseband signal from the power signal for receiving an error power signal, a pre-distortion update module configured for updating a piece wise linear function by adding a proportion of the error power signal to associated coefficients and a feed-forward pre-distortion apply module configured for applying an updated piece wise linear function onto the digital baseband signal. Thus, the error power signal is advantageously used as a measure to determine the pre-distortion to be applied.

According to a further embodiment of the invention, at least the digital baseband modulator and the digital feedback control loop are implemented in a Field Programmable Gate Array, FPGA, performing digital signal processing of the digital baseband signal and the digital pre-distortion signal. Preferably, the carrier frequency conversion device is also implemented and integrated together with the digital baseband modulator and the digital feedback control loop in the FPGA.

According to the invention, also a method for linearizing a RF amplifier for a magnetic resonance examination system is provided, comprising the steps of:
generating a digital baseband signal,
injecting a digital pre-distortion signal into the digital baseband signal,
providing an amplified analog output signal by the RF amplifier, which is driven by the pre-distorted digital base band signal, and
controlling the digital pre-distortion signal based on the analog output signal for compensating non-linearity of the RF amplifier.

The proposed method allows for linearizing the output of the RF power amplifier thereby removing restrictions on the bandwidth of the baseband demand signal i.e. the digital baseband signal such that an application of the method becomes especially advantageous when applied to advanced RF pulses such as required for multi-band MRI applications.

According to a further embodiment of the method, the step of controlling the digital pre-distortion signal comprises the steps:
determining a difference between the analog output signal and the digital baseband signal,
integrating the determined difference with a pre-defined integration time corresponding to the settling time of dynamic changes of the non-linearity of the RF amplifier,
adjusting the digital pre-distortion signal with a piece-wise linear approximation of the integrated difference, and
applying the adjusted digital pre-distortion signal onto the digital baseband signal by indexing the piece-wise linear approximation with a magnitude of the digital baseband signal to a gain and a phase offset of the analog output signal.

According to another embodiment of the invention, the method comprises the step of:
calibrating the digital pre-distortion signal in response to a reference digital baseband signal.

Further preferred embodiments of the method relate to the preferred embodiments of the system described before.

Further, according to the invention, a non-transitory computer-readable medium is provided, comprising instructions stored thereon, that when executed on a processor, perform the steps of the method as described before.

### BRIEF DESCRIPTION OF THE DRAWINGS

These and other aspects of the invention will be apparent from and elucidated with reference to the embodiments described hereinafter. Such an embodiment does not necessarily represent the full scope of the invention, however, and reference is made therefore to the claims and herein for interpreting the scope of the invention.

In the drawings:
Fig. 1 schematically depicts a simplified radio frequency, RF, transmit system according to a preferred embodiment of the invention,
Fig. 2 depicts a dynamic behavior of an RF amplifier controlled by a digital feedback control loop of the RF transmit system of Fig. 1 according to the preferred embodiment of the invention,
Fig. 3 depicts a signal path of the RF transmit system of Fig. 1 according to the preferred embodiment of the invention,
Fig. 4 depicts a pre-distortion function of the digital feedback control loop of Fig. 2 approximated by a piece wise linear function according to the preferred embodiment of the invention,
Fig. 5 depicts an implementation of the RF transmit system of Fig. 1 in an FPGA according to the preferred embodiment of the invention, and
Fig. 6 depicts a calibration procedure for the RF transmit system of Fig. 1 according to the preferred embodiment of the invention.

### DETAILED DESCRIPTION OF EMBODIMENTS

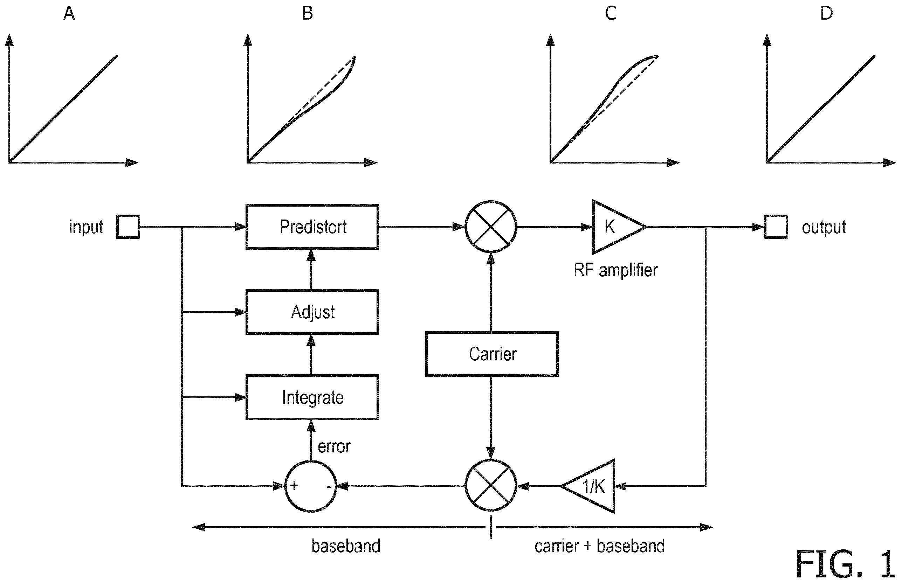

Fig. 1 depicts a simplified radio frequency, RF, transmit system according to a preferred embodiment of the invention for linearizing an RF amplifier by providing a control loop.

The RF amplifier introduces both signal dependent and time varying gain and phase errors that are compensated for by the control loop resulting in an RF amplifier output that follows its input accurately. The capability of the control loop to actually correct gain and phase errors depends on both their magnitude and dynamic behavior.

A pre-distortion function as digital feedback control loop 200, graph B in Fig. 1, is applied to a linear demand as digital baseband signal, graph A in Fig. 1, which when passed through a non-linear RF amplifier 400, graph C in Fig. 1, results in a linear output as analog output signal, graph D in Fig. 1. Thus, the described feedback control mechanism determines the pre-distortion function required to produce a linear output as analog output signal. The term pre-distortion means in the sense of the present invention a technique in which the demand to a non-linear RF amplifier 400 is deliberately distorted in order to counter act the non-linearity of the RF amplifier 400 in question.

Therefore, the per-distortion function maps an amplitude of an input i.e. the digital baseband signal to a gain and phase offset of the analog output signal that compensates for the non-linear behavior of the RF amplifier 400. The pre-distortion function thus compensates for signal dependent non linearity. As dynamic operating conditions of the RF amplifier 400 change over time, this results in a change in the required pre-distortion function. Thus, feedback control by means of the digital feedback control loop 200 is used to adjust the pre-distortion function to time varying operating conditions.

As can be seen from Fig. 1, the control loop operates in baseband with the baseband demand signal i.e. the digital baseband signal being mixed up with a carrier frequency prior to driving the RF amplifier 400. Further, the feedback signal is being mixed down to baseband for processing by the control loop.

The actual control loop provided by the digital feedback control loop 200 consists of the following operations:
Comparing the demand with the feedback signal that monitors the output of the RF amplifier 400. A difference in the RF amplifier 400 output i.e. the analog output signal with the demand i.e. the digital baseband signal results in an error that is subsequently compensated by the pre-distortion function.

Integration of the error allowing the control loop to track dynamic changes in the non-linear behavior of the RF amplifier 400. Thereby, the integration time constant defines the settling time associated with dynamic changes in the non-linearity.

Adjusting coefficients of the pre-distortion function defined through a piece-wise linear approximation with the integrated error.

Applying the pre-distortion function to the demand by indexing the piece-wise linear function with the amplitude of the input and adjusting the gain and phase of the demand accordingly.

Thereby, all baseband operations are performed as a function of the demand amplitude, which includes the integration of the error, the adjustment of the pre-distortion function and its subsequent application. The integration time constant defines the ability of the control loop to adjust to dynamic changes RF amplifier 400 non-linearity due to, for example, power supply voltage, temperature or load impedance. Any mechanism that causes a dynamic changes of RF amplifier 400 non-linearity can be compensated as long as it is bandwidth limited with respect to the integration time constant. The modulation bandwidth of the input signal i.e. the digital baseband signal, however, is not limited as the operation of the pre-distortion function is instantaneous.

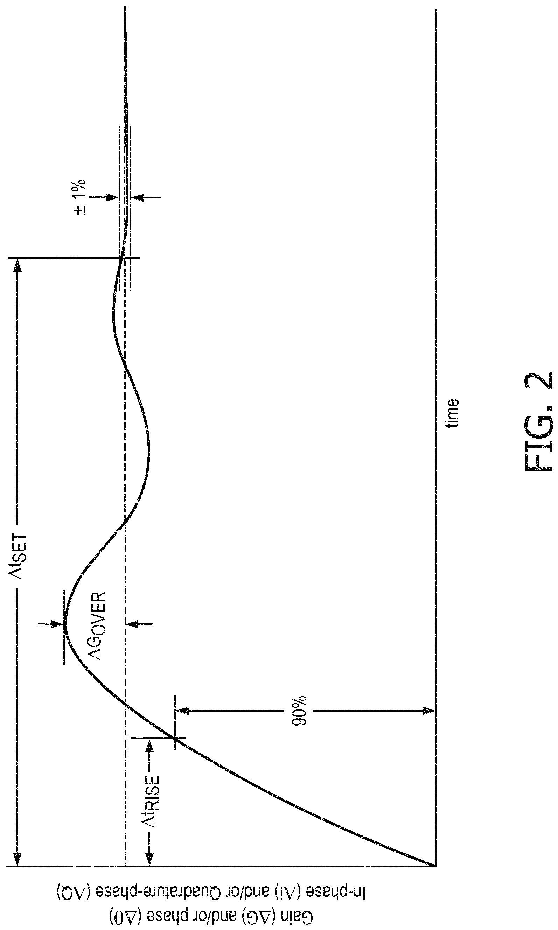

The typical performance of the digital feedback control loop 200, depicted in Fig. 2, is characterized by an amplitude accuracy of ≤ 0.05 dB respectively < 0.6%, a phase accuracy of ≤ 0.2, a rise time of ≤ 5 µ second, and an overshoot of ≤ 1 dB respectively < 12%, whereby a limit on the maximum overshoot may be advantageous for avoiding shutting down the RF amplifier 400 due to an excessive demand. Overshoot behavior can be optimized by controlling the gain of the error signal integrator, a high gain resulting in a faster response and a low gain in less or no overshoot. Further, the digital feedback control loop 200 is characterized by a settling time of ≤ 20 µ second and a baseband bandwidth of ≤ ±500 KHz as the modulation bandwidth of the baseband signal amplitude, frequency and phase, whereby the RF transmit bandwidth is typically ≤ ±350 KHz. The frequency range of carrier frequencies at which the control loop operates is 5 MHz to 300 MHz and covers all MR resonance frequencies for usable nuclei at IT, 1.5T, 3T and 7T. Further, the feedback delay is ≤ 5 µ second, whereby the maximum delay of the feedback signal measured from the output of the DAC 401 to the input of the ADC 404, which limits any delays introduced by the RF amplifier 400 and feedback signal electronics i.e. the digital feedback control loop 200. In practice, the feedback delay is less than 1 µ second.

Requirements on dynamic behavior of the RF amplifier 400 controlled by the digital feedback control loop 200 are defined in terms of a step response behavior, which is characterized in terms of rise time Δt_{RISE}, overshoot Δ_{OVER} and settling time Δt_{SET} as illustrated in Fig. 2. Thereby, dynamic response characteristics apply to both the gain and phase response in polar coordinates and in-phase and quadrature-phase components in Cartesian coordinates. Specifically, Δt_{RISE} is the rise time required to reach 90% of the requested step gain/phase, Δ_{OVER} is the maximum overshoot relative to requested step gain/phase and Δt_{SET} is the time required to settle to within 1% of the required gain/phase.

The step response characteristics applies to the dynamic behavior of the error signal, not the input signal. A step response to the error signal is only possible if there is a step response in the gain and/or phase of the RF amplifier 400 itself.

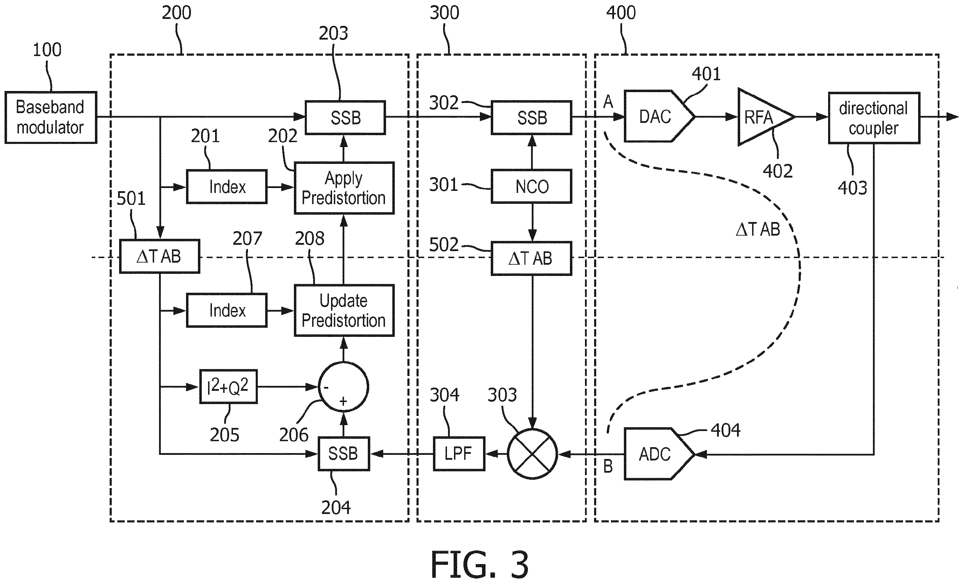

Fig. 3 depicts a signal path of the RF transmit system of Fig. 1 according to the preferred embodiment of the invention. Thereby, the RF transmit system produces an unknown gain and phase of the feedback signal path as introduced by various analog components. Thus, the described RF transmit system is designed for a nominal gain of unity but a precise actual gain and phase is required in order to conform to accuracy requirements. Once calibrated, feedback control of the RF transmit system ensures that the calibrated gain and phase are maintained. Further, delay of the feedback signal ΔT is unknown, as it is introduced by components external to the control loop. These include DAC 401, RF amplifier 402, directional coupler 403, feedback signal conditioning and ADC 404. Lastly, signal processing is required to extract from the feedback signal the actual gain and phase errors introduced by the RF amplifier 400.

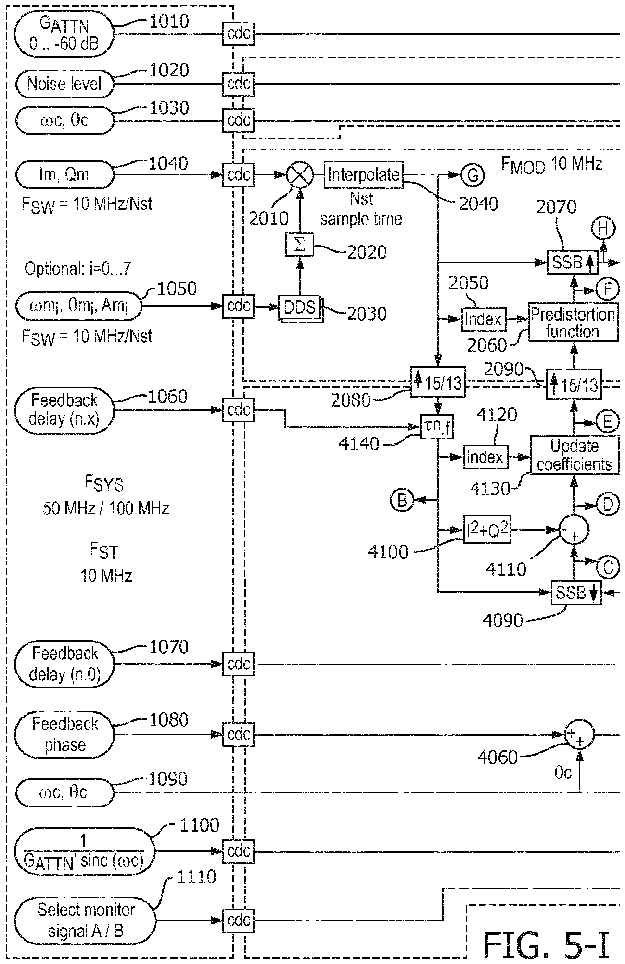

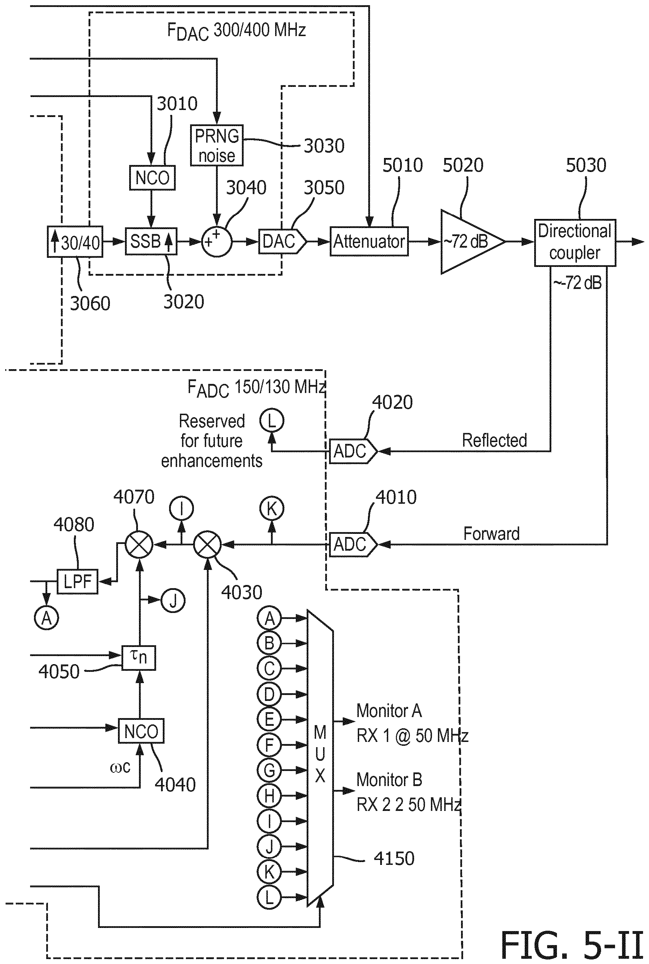

Now actually turning to Fig. 3, a digital baseband modulator 100 generates the digital baseband signal, also referred to as demand. The digital baseband signal is processed by the digital feedback control loop 200, mixed up by the carrier frequency conversion device 300 to the carrier frequency and subsequently used to drive the RF amplifier 400. The digital baseband modulator 100, digital feedback control loop 200 and carrier frequency conversion device 300 are all performed through digital signal processing and implemented in an FPGA, as shown in Fig. 5.

All signal processing in the RF transmit system is performed in complex coordinates allowing accurate control over both the gain and phase of the analog output signal provided by the RF amplifier 400. A pre-distorted digital base band signal received from the digital feedback control loop 200 respectively the carrier frequency conversion device 300 is converted in the RF amplifier 400 to an analog signal by a DAC 401 which is used to drive the actual RF power amplifier device 402. A control loop feedback signal is detected on a forward port of a directional coupler 403 and subsequently converted to a digital signal by an ADC 404. By using forward power of the directional coupler 403 as feedback signal the digital feedback control loop 200, also referred to as control loop in the following, ensures that the forward power of the RF amplifier 400 follows the demand.

The complex carrier frequency is generated in the carrier frequency conversion device 300 by an Numerically Controlled Oscillator, NCO, 303 which is used to shift the complex baseband signal up to the carrier frequency though a Single Side Band, SSB, modulator 302, an entity in the digital design used to impose a complex modulation signal on a single side band of a carrier frequency. This same carrier frequency is used to shift the real valued feedback signal down to baseband with mixer 303. A low pass filter 304 removes the unwanted mixer product at twice the carrier frequency to produce a 'clean' baseband signal for further processing by the control loop 200.

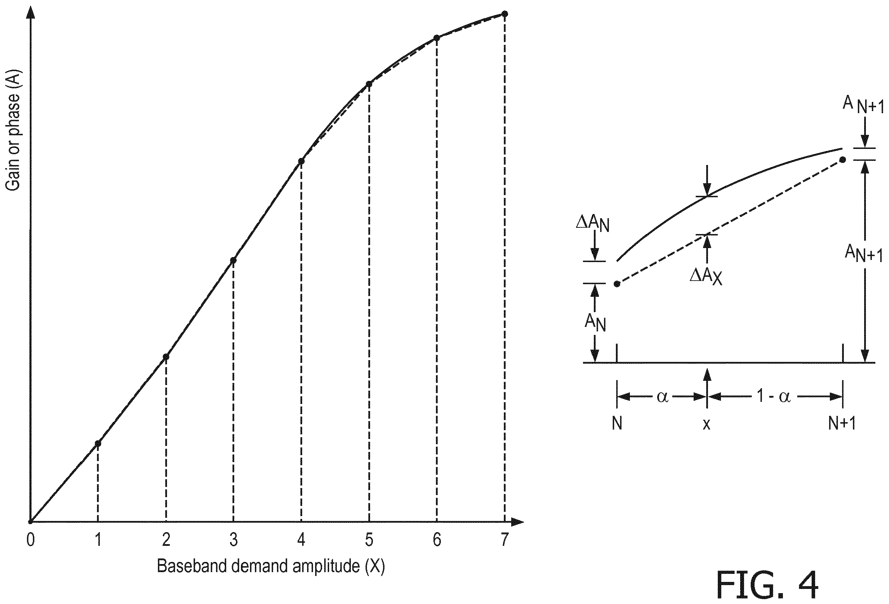

The feedback signal is multiplied by original baseband signal with a SSB modulator 204 to form a power signal. The power of the original baseband demand is computed 205 and subtracted from the feedback power signal by a subtraction module 206 to form the error power signal. The error power is used as a measure to estimate the pre-distortion function applied by the digital feedback control loop 200 as digital pre-distortion signal. Thereby, the pre-distortion function of the digital feedback control loop 200 is approximated by a piece wise linear function as depicted in Fig. 4.

For a particular baseband demand amplitude (X in Fig. 4), the corresponding line segment (N to N+1) is determined 207. The error power (ΔAx) defines the error of the pre-distortion function for the corresponding baseband demand amplitude (X). The piece wise linear function is updated by a pre-distortion update module 208 by adding a proportion of the error power to the associated coefficients (A_{N} and A_{N+1}). The amount added is proportional to the offsets (α and 1- α) of the demand amplitude (X) to the demand amplitudes (N and N+1) associated with the line segment in question. In this manner, the coefficients (A_{N} and A_{N+1}) are updated to reflect the error detected by the feedback signal. Adding the error power to the pre-distortion function coefficients has the effect of integrating the error. The integration gain and corresponding integration time constant and settling time can be controlled by adjusting the proportion of the error to be added. This allows the integration gain to be adjusted as function of the baseband demand amplitude ensuring that the control loop settling time is independent of the demand.

The pre-distortion function 202 is indexed by the demand amplitude 201 by a feed-forward pre-distortion apply module 202 and applied to the baseband demand with a SSB modulator 203. The coefficients of the pre-distortion function 207 maintained in the feedback path are passed directly to the feed forward pre-distortion function 202. In this fashion, the pre-distortion function of the digital feedback control loop 200 providing the digital pre-distortion signal is applied as a feed forward control while the pre-distortion function is updated via feedback control.

However, there is a considerable delay (ΔT AB) in the signal path from the input to the DAC 401 at point A to the output of the ADC 404 at point B, see Fig. 3. Uncompensated, this delay would introduce a significant gain and phase errors when comparing the feedback signal with the demand 206. To ensure phase coherency between baseband demand and feedback signal, the baseband signal is delayed 501 and the carrier frequency signal is delayed 502 by a delay (ΔT AB) that corresponds to the delay in the external signal path. For the control loop to operate properly, this delay is calibrated accurately, as explained later.

Fig. 5 shows an implementation of the RF transmit system of Fig. 1 in an FPGA according to the preferred embodiment of the invention. Thereby, a number of additional measures are required that are primarily associated with choosing appropriate sampling frequencies for digital signal processing and for characterizing and monitoring control loop behavior as well as performing the necessary calibrations. In particular, clock domains for interface is 10/50/100 MHz depending on interfacing component, for baseband is 10 MHz fixed for all field strengths, for carrier is 300/400 MHz with 300 MHz for operation up to 3 Tesla and 400 MHz for operation at 7 Tesla, and for feedback is 150/130 MHz with 150 MHz for operation up to 3 Tesla and 130 MHz for operation at 7 Tesla. These sampling frequencies are convenient for commercially available FPGA, DAC and ADC components. The control loop can however operate at any set of sampling frequencies as long as the chosen sampling frequencies conform to Nyquist sampling criteria.

The control loop can be interfaced to various system components. The clock frequency depends on the component in question. Modulation waveforms are typically generated via time scheduled control with a RF pulse waveform generators running at 10 MHz. The baseband demand signal is generated at the modulation frequency rate F_{MOD}. This is 10 MHz for both 3T and 7T TCI variants and is thus well above the Nyquist sampling rate associated with the required baseband bandwidth. In practice the baseband bandwidth is restricted by the limited bandwidth of the RF amplifier 400 and subsequent antenna resonator, typically less than 1 MHz. The carrier frequency demand signal is generated at the DAC sampling frequency F_{DAC}. This is 300 MHz for the standard TCI and 400 MHz for the 7T variant. The feedback control loop operates at the ADC sampling frequency rate F_{ADC}. This is 150 MHz for the standard TCI and 130 MHz for the 7T variant. These frequencies conform to the Nyquist sampling rate under bandwidth limited sampling conditions.

The up sampling filters on the clock domain crossings are used to transfer the baseband signal at F_{MOD} to DAC and ADC frequency domains operating at F_{DAC} and F_{ADC} respectively. The F_{DAC} and F_{ADC} frequencies are both multiples of F_{MOD} in order to simplify clocking and ensure phase coherence between the various clock domains. The choice of F_{DAC} and F_{ADC} is limited by component availability and depends strongly on the actual carrier frequencies associated with various nuclei at a particular magnetic resonance, MR, field strength. The limited DAC and ADC sampling frequencies result in aliasing and under sampling for various carrier frequencies. The various components of the FPGA implementation are described in the symbol reference list provided below, which is incorporated by reference.

The DAC 3050 gain follows a sinc function (sin(x)/x) which is compensated via the attenuator 5010 and the modulation waveform amplitude for a nominal gain at the input of the RF amplifier. A certain amount of gain headroom must be allocated at the output of the DAC 3050 for this purpose as well as to enable the control loop to compensate for errors introduced by the RF amplifier 400. Additional headroom may be required to account for cable losses to the RF amplifier 400 when the digital control loop logic is not integrated in the RF amplifier. In the forward signal path, a SSB, single side band, also referred to as SBB modulator, 3020 shifts the baseband demand to the carrier frequency to form the carrier demand. SSB 2070 adjusts the baseband demand signal with a correction factor defined by the pre-distortion function. The adjusted baseband demand is equal to the baseband demand when the pre-distortion correction factor is zero and/or when the control loop is open.

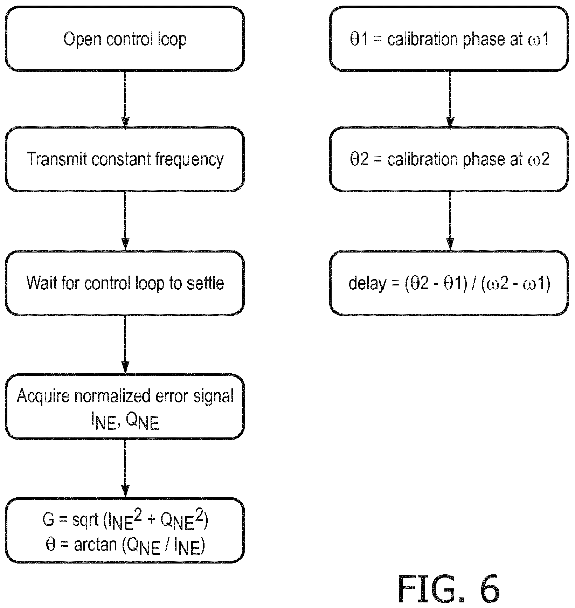

Fig. 6 shows a basic calibration procedure required to characterize analog components in the feedback path. The normalized error signal (I_{NE} and Q_{NE} values) define the complex gain of the open loop feedback signal. Converting to polar coordinates provides the scalar gain (G) and phase (θ). A delay measurement consists of determining the calibrated phase at different frequencies, as shown on the right side of Fig. 6. The chosen frequency difference is a compromise between the expected range of delay values and the accuracy of the measurement.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope. Further, for the sake of clearness, not all elements in the drawings may have been supplied with reference signs.

### REFERENCE SYMBOL LIST

- 100: digital baseband modulator
- 200: digital feedback control loop
- 201: index module
- 202: feed-forward pre-distortion apply module
- 203: single side band modulator
- 204: loop single side band modulator
- 205: computing module
- 206: subtraction module
- 207: index module
- 208: pre-distortion update module
- 300: carrier frequency conversion device
- 301: carrier frequency generator
- 302: carrier single side band modulator
- 303: carrier frequency generator
- 304: low pass filter
- 400: RF amplifier
- 401: digital-to-analog converter
- 402: RF amplifier
- 403: direct coupler
- 404: analog-to-digital converter
- 501: delay module
- 502: delay module
- 1010: G_{ATTN}; Attenuator setting
- 1020: Noise level; Amplitude of PRNG noise to be added to the carrier signal. Adding noise reduces spurious signals in the digital carrier signal generated by the DAC at the cost on an increased noise floor.
- 1030: ωc, θc; Carrier frequency and phase. The carrier frequency is defined as a phase increment at F_{DAC}.
- 1040: Im, Qm; Complex baseband modulation waveform sample. A sequence of samples, typically on a regular sample grid, is required to define a RF pulse modulation waveform.
- 1050: ωmᵢ, θmᵢ, Amᵢ; Baseband frequency, phase and amplitude sample. A sequence of samples, typically on a regular sample grid, is required to define a RF pulse modulation waveform.
- 1060: Feedback delay (n.x); Fractional feedback delay. The feedback delay is expressed in FADC samples and has an integer component (n) and fractional component (x).
- 1070: Feedback delay (n.0); Integral feedback delay. The feedback delay is expressed in an integral number of F_{ADC} samples.
- 1080: Feedback phase; Feedback carrier frequency phase. The feedback phase is used to define the fractional delay as a phase of the carrier frequency.
- 1090: ωc, θc; Carrier frequency and phase. The carrier frequency is defined as a phase increment at F_{ADC}.
- 1100: G_{ATTN} sinc(ωc); Attenuator gain compensation.
- 1110: Select monitor signal A / B; Select the monitoring signals to be output to receivers RX 1 and RX 2.
- 2010: Multiplier; Multiplies the complex modulation waveform with the composite Direct Digital Synthesizer, DDS, generated modulation waveform.
- 2010: ∑; Combines the DDS generated modulation waveforms to a single composite baseband modulation waveform.
- 2030: DDS; One of a number of DDS waveform generators. The number of DDS waveform generators is a configuration parameter. The DDS waveform generators allow the baseband modulation waveform to be generated in terms of frequency, phase and amplitude waveforms.
- 2040: Integrator; Interpolates the sampled baseband modulation waveform to F_{MOD}. The interpolator allows the system to define baseband modulation waveforms at a frequency lower than F_{MOD} reducing digital network bandwidth and compute performance.
- 2050: Index; Indexes the pre-distortion function with the amplitude of the baseband modulation waveform.
- 2060: Pre-distortion function; Maps the index to a complex correction factor to be applied to the baseband signal.
- 2070: SSB; Adjusts the baseband signal with the pre-distortion correction factor.
- 2080: 15/13; Rate conversion of baseband signal at F_{MOD} to F_{ADC}.
- 2090: 15/13; Rate conversion of pre-distortion coefficients update at F_{ADC} to F_{MOD}.
- 3010: NCO, numerically controlled operator; Carrier frequency generator operating at F_{DAC}.
- 3020: SSB; Shifts the baseband signal up to the carrier frequency.
- 3030: PRNG noise; Pseudo random number noise generator.
- 3040: Adder; Adds noise to the digital carrier frequency signal.
- 3050: DAC; Digital to analog conversion of carrier frequency signal.
- 4010: ADC; Forward power analog to digital converter.
- 4020: ADC; Reflected power analog to digital converter. The reflected power signal is reserved for future extensions.
- 4030: Multiplier; Adjust the feedback signal to match the calibrated gain of the attenuator and the sin(x)/x gain of the DAC.
- 4040: NCO; Carrier frequency generator operating at F_{ADC}.
- 4050: τn; Delay the feedback signal to match the signal delay of the external components. Only compensates an integral delay at F_{ADC}.
- 4060: Adder; Adds the carrier frequency phase associated with the fractional feedback delay to the requested carrier frequency phase.
- 4070: Mixer; Convert the carrier feedback to a baseband signal also generating a second harmonic product.
- 4080: LPF; Remove the second harmonic mixer product from the feedback signal.
- 4090: SSB; Convert the baseband feedback signal to a power signal.
- 4100: I²+Q²; Compute the power of the baseband signal.
- 4110: Adder; Subtracts the baseband power from the feedback power signal to form the error power.
- 4120: Index; Indexes the pre-distortion function with the amplitude of the baseband modulation waveform selecting the coefficients to be updated with the error power.
- 4130: Update coefficients; Proportionally add the error power to the selected pre-distortion coefficients effectively integrating the residual error power signal.
- 4140: τ_{n.f}; Delay the baseband signal to match the signal delay of the external components.
- 4150: MUX; Selects one or two of the monitoring signals to be output to receiver RX 1 and receiver RX 2 respectively.

## Claims

1. A radio frequency, RF, transmit system for a magnetic resonance examination system, comprising
a digital baseband modulator (100) configured for generating a digital baseband signal,
a digital feedback control loop (200) configured for injecting a digital pre-distortion signal into the digital baseband signal,
an RF amplifier (400) configured for being driven by the pre-distorted digital base band signal and for providing an analog output signal, wherein
the digital feedback control loop (200) is configured for controlling the digital pre-distortion signal based on the analog output signal to compensate a non-linearity of the RF amplifier (400).

2. The system according to the proceeding claim, wherein the digital feedback control loop (200) is configured for controlling the digital pre-distortion signal by mapping an amplitude of the digital baseband signal to a gain and a phase offset of the analog output signal.

3. The system according to any of the proceedings claims, wherein digital feedback control loop (200) is configured for controlling the digital pre-distortion signal by
determining a difference between the analog output signal and the digital baseband signal,
integrating the determined difference with a pre-defined integration time corresponding to a settling time of dynamic changes of the non-linearity of the RF amplifier (400),
adjusting the digital pre-distortion signal with a piece-wise linear approximation of the integrated difference and
applying the adjusted digital pre-distortion signal onto the digital baseband signal by indexing the piece-wise linear approximation with a magnitude of the digital baseband signal to a gain and a phase offset of the analog output signal.

4. The system according to any of the proceedings claims, wherein the digital feedback control loop is configured for calibrating the digital pre-distortion signal in response to a reference digital baseband signal.

5. The system according to any of the proceedings claims, wherein the RF amplifier (400) comprises a digital-to-analog converter (401) configured for converting the pre-distorted digital base band signal for driving the RF amplifier (400), a directional coupler (403) connected to an output of the RF amplifier (400) and an analog-to digital converter (404) configured for converting a control loop feedback signal derived from the directional coupler (403) and for providing the converted loop feedback signal to the digital feedback control loop (200) for controlling the digital pre-distortion signal.

6. The system according to any of the proceedings claims, comprising a carrier frequency conversion device (300) arranged between the digital feedback control loop (200) thereby receiving the digital pre-distortion signal and the RF amplifier (400) thereby driving the RF amplifier (400) with the pre-distorted digital base band signal and to shift the digital pre-distortion signal up to a carrier frequency.

7. The system according to the proceeding claim, wherein the carrier frequency conversion device (300) comprises a carrier frequency generator (301) configured for generating the carrier frequency, a carrier single side band modulator (302) configured for shifting the digital baseband signal up to the carrier frequency, a mixer (303) connected to carrier frequency generator (301) and configured for shifting the analog output signal down to a feedback baseband signal and a low pass filter (304) configured for removing unwanted mixer signal from the feedback baseband signal at twice the carrier frequency.

8. The system according to any of the proceedings claims, wherein the digital feedback control loop (200) comprises a second single side band modulator (204) configured for forming a power signal from the analog output signal, a subtraction module (206) configured for subtracting the digital baseband signal from the power signal for receiving an error power signal, a pre-distortion update module (208) configured for updating a piece wise linear function by adding a proportion of the error power signal to associated coefficients and a feed-forward pre-distortion apply module (202) configured for applying an indexed updated piece wise linear function onto the digital baseband signal.

9. The system according to any of the proceedings claims, wherein at least the digital baseband modulator (100) and the digital feedback control loop (200) are implemented as a Field Programmable Gate Array, FPGA, performing digital signal processing of the digital baseband signal and the digital pre-distortion signal.

10. A method for linearizing a radio frequency, RF, amplifier (400) for a magnetic resonance examination system, comprising the steps of:
generating a digital baseband signal,
injecting a digital pre-distortion signal into the digital baseband signal,
providing an amplified analog output signal by the RF amplifier (400), which is driven by the pre-distorted digital base band signal and,
controlling the digital pre-distortion signal based on the analog output signal for compensating non-linearity of the RF amplifier (400).

11. The method according to the proceeding method claim, wherein the step of controlling the digital pre-distortion signal comprises the steps:
determining a difference between the analog output signal and the digital baseband signal,
integrating the determined difference with a pre-defined integration time time corresponding to a settling time of dynamic changes of the non-linearity of the RF amplifier (400),
adjusting the digital pre-distortion signal with a piece-wise linear approximation of the integrated difference, and
applying the adjusted digital pre-distortion signal onto the digital baseband signal by indexing the piece-wise linear approximation with magnitude of the digital baseband signal to a gain and a phase offset of the analog output signal.

12. The method according to any of the proceedings method claims, comprising the step of:
calibrating the digital pre-distortion signal in response to a reference digital baseband signal.

13. A non-transitory computer-readable medium, comprising instructions stored thereon, that when executed on a processor, perform the steps of the method according to the previous claim.
